# EUROPÄISCHE PATENTSCHRIFT

(11) **EP 1 854 905 B1**
(45) Veröffentlichungstag und Bekanntmachung des Hinweises auf die Patenterteilung: **17.10.2012**
(21) Anmeldenummer: 07008991.7
(22) Anmeldetag: 04.05.2007
(51) Int. Cl.: C23C 16/16, C23C 16/56, C23C 16/04, C23C 16/02

(54) **Verfahren zur Herstellung von Bauteilen für den Raketenbau**
Method for manufacturing components for rocket construction
Procédé de fabrication de composants pour la construction de raquettes

(30) Priorität: 08.05.2006 DE 102006021539
(43) Veröffentlichungstag der Anmeldung: 14.11.2007
(73) Patentinhaber: Astrium GmbH, 81663 München (DE)
(72) Erfinder: Gröber, Josef, 81737 München (DE); Taubenberger, Gerhard, 82008 Unterhaching (DE); Stahn, Bernhard, 82057 Icking (DE)
(74) Vertreter: Hummel, Adam

(56) Entgegenhaltungen:
- US-A- 4 759 950
- US-A- 5 008 160
- US-A- 5 470 651
- US-A- 6 132 518
- US-B1- 6 838 191

## Beschreibung

Die Erfindung betrifft ein Verfahren zur Herstellung von Bauteilen für den Raketenbau.

Zur Herstellung von Bauteilen für den Raketenbau, z.B. von Tragstrukturen für Schubkammern, sind verschiedene Verfahren bekannt, z.B. galvanische Nickelabscheidung, Schweißtechniken oder Lötverfahren.

Derzeit werden insbesondere Tragstrukturen für Schubkammern im Raketenbau durch galvanische Nickelabscheidung, Schweißtechniken, Lötverfahren oder andere Verfahren erzeugt. Speziell die galvanische Nickelabscheidung (0,01 bis 0,02mm/h) hat den Nachteil sehr hoher Durchlaufzeiten im Fertigungsprozess.

Die sehr viel höhere Abscheidungsrate (0,25mm/h) im NVD-Verfahren verkürzt die Durchlaufzeit wesentlich und verringert damit die gesamte Entwicklungsdauer.

Die Verwendung von keramischen Bauteilen für Schubkammern hat den Nachteil, dass die erzeugten Hohlkörper bauartbedingt nicht ausreichend gasdicht sind. Dies ist in vielen Einsatzgebieten nicht erlaubt. Zur Abdichtung der Oberflächen sind galvanische Beschichtungen und Silizium beinhaltende Beschichtungen in der Erprobungsphase.

Das NVD-Verfahren ermöglicht durch seine Charakteristik einer Abscheidung in kleinen Hohlräumen die Oberfläche abzudichten. Bei fortgesetzter Abscheidung kann zusätzlich eine äußere Tragstruktur entsprechend der einsatzbedingten Belastung erzeugt werden. Das Verfahren bietet weiter die Möglichkeit Versteifungs-, Anschluss- und Verbindungselemente wie zum Beispiel Rippen, Stege, Flansche, Schweißansätze, Anschraubflächen, Halterungen und Laschen mit aufzubauen oder aus der aufgetragenen Dickschicht durch mechanische Bearbeitung herzustellen. Speziell bei keramischen Bauteilen mit unregelmäßigen Oberflächenstrukturen und stark schwankender Formgenauigkeit entfällt damit die Notwendigkeit einer mechanischen Bearbeitung bevor die Verbindungselemente aus Metall passgenau durch Formschlusselemente oder formschlüssige Verankerung mit der Oberflächenstruktur verbunden und /oder abgedichtet werden können.

Das Verbinden zweier Bauteile durch Schraub-, Schweiß-, Löt- und Galvano-Technik sind allgemein bekannte Verfahren.

Das NVD-Verfahren bietet zusätzlich die Möglichkeit Bauteile aus Nickel mit Bauteilen aus anderen Werkstoffen mechanisch durch Hinterschneidungen, Aufrauung oder andere ankerförmige Formgebungen des Grundkörpers zu verbinden.
Die mechanische Verbindung eines gefrästen metallischen Kühlkörpers mit einem Last tragenden Mantel kann so zum Beispiel hergestellt werden.

Ferner ist im Stand der Technik das Nickel-Vapor-Deposit-Verfahren (NVD-Verfahren) bekannt. Beim NVD-Verfahren wird in einer speziellen Beschichtungskammer Nickeltetrakarbonylgas über ein temperiertes Modell geführt und in einem chemischen Prozess an der Modelloberfläche als Reinnickel abgeschieden. Eines der Hauptanwendungsgebiete des NVD-Verfahrens ist die Herstellung von Nickelwerkzeugen, z.B. Nickelschalen für Küchenspülenwerkzeuge. Das NVD-Verfahren wird hauptsächlich im Formenbau eingesetzt wird. Dabei wird Nickel im NVD-Verfahren auf einer Negativform abgeschieden. Die aufgetragene Nickelschale wird von der Negativform getrennt und als Bauteil genutzt. Die Erzeugung einer Nickelschale mittels Negativform hat den Nachteil, dass die Herstellung und Anbringung einer Tragstruktur auf konturierte, hinterschnittene Grundkörper (z.B. Brennkammern mit Düsenerweiterung für Raketentriebwerke) nur durch eine integrationsbedingte Teilung der Nickelschale möglich ist. Dadurch sind weitere Prozessschritte bei der nachfolgenden Integration für die Verbindung der einzelnen Nickelschalen untereinander und mit dem Grundkörper erforderlich. Dieser Zusatzaufwand bei der Herstellung und die erheblichen Qualitätsrisiken durch das erforderliche Nachstellen der Tragstruktur haben dieses NVD-Verfahren für die Herstellung von Raketenbauteilen bisher als ungeeignet erscheinen lassen.

Aus diesem Grund ist das NVD-Verfahren zur Herstellung von Bauteilen für den Raketenbau, z.B. Tragstrukturen für Schubkammem, nicht verwendet worden und folglich ist eine Verwendung des NVD-Verfahrens dafür auch nicht bekannt.

Die US 5,008,160 offenbart ein Verfahren zur Herstellung von Composite-Bauteilen, bei dem auf ein metallisches Grundsubstrat zunächst eine erste Metallschicht aufgebracht wird, welche hinsichtlich der Haftung zu dem Grundkörper besondere Eigenschaften aufweist. Ferner wird eine zweite Schicht auf die erste Schicht aufgebracht. Das Aufbringen der zweiten Schicht erfolgt als CVD mit Karbonylgas.

Die US 6,838,191 offenbart verschiedene Verfahren zum Aufbringen einer Nickelschicht als Beschichtung in einer Verbrennungskammer eines Raketenantriebs.

Die US 5,470,651 offenbart ein NVD-Verfahren, bei dem eine durch dieses Verfahren erzeugte Nickelschicht von dem Substrat abgenommen wird.

Es ist eine Aufgabe der Erfindung ein Verfahren für die Herstellung von Bauteilen für den Raketenbau anzugeben, welches eine hohe Abscheidungsrate hat, in der Lage ist gleichmäßig dicke Nickelschichten oberflächentreu auf bellebig geformten Grundkörpern aufzutragen und in der Lage ist Nickelschichten in offenen Hohlräumen abzutragen.

Die Aufgabe wird gelöst durch ein Verfahren nach Anspruch 1. Weitere vorteilhafte Ausgestaltungen der Erfindung sind in den Unteransprüchen zu finden.

Erfindungsgemäß ist ein Verfahren zur Herstellung von Bauteilen für den Raketenbau vorgesehen, umfassend die Schritte des Bereitstellens eines Grundkörpers, der Abscheidung von Nickel im NVD-Verfahren auf den Grundkörper, und die Weiterbehandlung der Verbindung des Grundkörpers mit der Nickelschicht als Bauteil. Das Verfahren zeichnet sich durch die Verwendung eines Bauteils einer Rakete als Grundkörper aus, wobei das Bauteil eine poröse keramische und/oder eine nichtkeramische Faserverbundstruktur umfasst, wobei durch die Abscheldung von Nickel eine Oberflächenabdichtung gegen Gase und Flüssigkeiten bewirkt wird.

In einer Ausgestaltung ist das Bauteil einer Rakete gekühlt oder nicht gekühlt.

In einer weiteren Ausgestaltung wird als zusätzlicher Schritt vor dem Schritt des Abscheidens von Nickel auf das Bauteil einer Rakete im Bereich der Bindezone zum NVD-Nickel oder einem anderen Teilbereich davon der Grundkörper galvanisch mit einem Lot beschichtet.

Die Erfindung schlägt ferner die Verwendung eines NVD-Verfahrens zur Abscheidung von Nickel auf einem Grundkörper vor, der ein Bauteil einer Rakete ausbildet und der eine poröse keramische und/oder nichtkeramische Faserverbundstruktur umfasst, zur Ausbildung einer Beschichtung zur Oberflächenabdichtung gegen Gase und Flüssigkeiten.

Ein Vorteil des erfindungsgemäßen Verfahrens ist es, dass die Vorteile der hohen Abscheidungsrate, der oberflächentreuen Auftragung gleichmäßig dicker Nickelschichten auf beliebig geformten Körpern und das Abtragen in offenen Hohlräumen des NVD-Verfahrens genutzt werden können.

Eine Eigenschaft des erfindungsgemäßen Verfahrens ist es, dass im Gegensatz zum Stand der Technik bei dem erfindungsgemäßen Verfahren der Grundkörper zusammen mit der aufgebrachten Nickelschicht als Bauteil weiterverwendet wird und nicht die aufgebrachte Nickelschicht nachdem sie zuvor vom Grundkörper gelöst worden ist. Durch dieses Merkmal wird das NVD-Verfahren für die Herstellung von Bauteilen in der Raketentechnik anwendbar.

Das Verfahren wird als nächstes anhand der Figuren 1 bis 6 näher beschrieben. Die Figuren zeigen:
- Fig. 1: Linke Schnittdarstellung: Brennkammergrundkörper (10) mit offenen Kühlkanälen (25) im Anschlussbereich der Nickelschicht (14). Rechte Schnittdarstellung: Brennkammergrundkörper (10) mit geschlossenen Kühlkanälen (15) im Anschlussbereich der Nickelschicht (14).
- Fig. 2: Brennkammergrundkörper (10) mit Kühlkanälen und Füllmaterial (13) wobei 3 verschiedene Möglichkeiten einer formschlüssigen Anbindung der Nickelschicht an den Grundkörper dargestellt sind:
- Beidseitige rillenförmige Hinterschneidung (16a).
- Microstrukturelle Oberflächegestaltung an der Stirnfläche (16b) der Kühlkanalstege zur Verankerung der Nickelschicht.
- Microstrukturelle Operflächegestaltung an den Seitenflächen (16c) der Kühlkanalstege zur Verankerung der Nickelschicht.
- Fig. 3: Grundköper aus Verbund einzelner runder (12a) oder rechteckiger (12b) Röhrchen mit aufgebrachter Tragschicht (14) aus Nickel.
- Fig. 4: Eine erfindungsgemässe keramische Grundstruktur (11) mit Kühlkanälen und Zuführungsöffnungen und einer außen und stirnseitig aufgebrachten Nickelschicht (17), deren Endkontur mit Rippen und Stege (21) anschließend durch mechanische Bearbeitung erzeugt wird. Zusätzlich bewirkt die NVD-Beschichtung bei porösen Grundstrukturen eine Abdichtung (18) gegen Gase und Flüssigkeiten.
- Fig. 5: Grundkörper, Tragschicht und Verteilungsring als Integrales Bauteil (19) mittels NVD-Beschichtung hergestellt unter Verwendung geeigneter Kernmaterialien (22) zur Gestaltung und Herstellung der Hohlräume und anschließender mechanischer Bearbeitung der Außenkontur (20).
- Fig. 6: Spalt- und kraftfrele, formschlüssige Verbindung von Grundkörpern (24) aus einer porösen keramischen und/oder nichtkeramischen Faserverbundstruktur mit einer Nickelschicht (23) zur Herstellung von Tragstrukturen und /oder Basismaterial für die Gestaltung von Verbindungen und Anschlussgeometrien oder die Herstellung integraler Gelenkverbindungen.

Das NVD-Verfahren kann für folgende Anwendungszwecke eingesetzt werden: (1) Herstellung von Brennkammer-Grundkörpern mit Kühlkanälen aus NVD-Nickel, (2) Herstellung von Brennkammer-Tragstrukturen und den erforderlichen Zu- und Abströmverteilern als integrales Bauteil für Raketenantriebe und Gasgeneratoren, (3) Herstellung von Tragstrukturen auf keramischen Bauteilen, (4) Beschichtung keramischer Bauteile für den Raketenbau zur Oberflächenabdichtung, (5) Herstellung von Verbindungselementen auf keramischen Grundstrukturen, (6) Mechanische Verbindung von Grundkörpern mit einem Nickelmantel und (7) NVD-Abscheidung in Kombination mit einer Lötverbindung.

Bei den genannten Anwendungen werden die Vorteile der hohen Abscheidungsrate, der oberflächentreuen Auftragung gleichmäßig dicker Nickelschichten auf beliebig geformten Körpern und das Abtragen in offenen Hohlräumen des NVD-Verfahrens genutzt.

Zunächst wird die Herstellung von Tragstrukturen auf verschiedenen Bauteilen gemäß dem erfinderischen Verfahren beschrieben.

Der zu beschichtende Grundkörper wird in bekannter Weise in der NVD-Kammer positioniert und vorbereitet. Mit Hilfe des NVD-Verfahrens wird dann eine bestimmte Nickelschicht aufgetragen, die als Tragstruktur verwendet wird. Die Verbindung des Grundkörpers mit der Nickelschicht wird dann als Bauteil weiterbearbeitet.

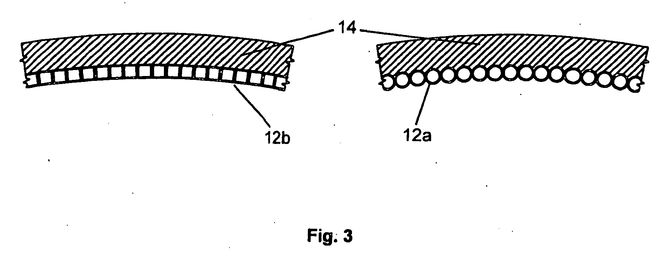

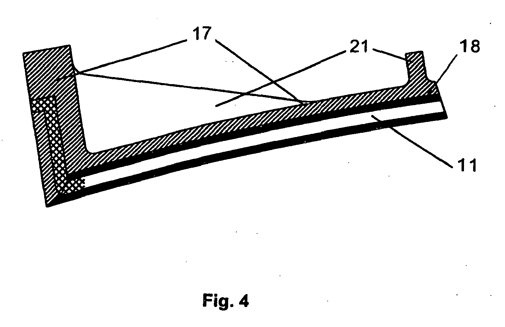

In der Raketentechnik soll die NVD-Beschichtung beim Erzeugen thermisch und strukturmechanisch sehr hoch belasteter metallischer und nichtmetallischer Kühlkörper verwendet werden. Dies wären Brennkammern, Expansionsdüsen und gekühlte Gasgeneratoren. Der zu beschichtende Grundkörper besteht dabei aus einer erfinderischen keramischen Faserverbund-Struktur (Fig.4) oder aus einem Verbund röhrchenförmiger Einzelelemente (Fig.3).

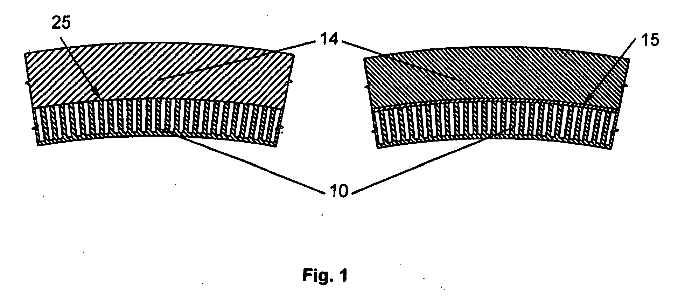

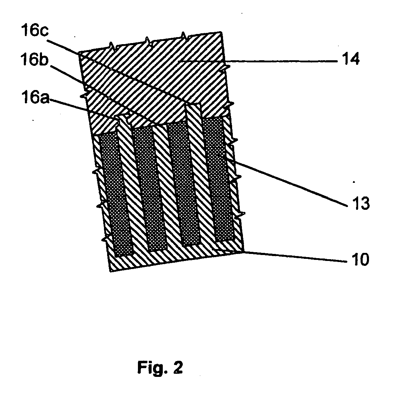

Die Beschichtung kann dann auf verschiedene Arten durchgeführt werden. (Fig.1 und 2)
A) Beschichtungsseitig offene Kühlkanäle (25):
   a) Die Kühlkanäle werden mit einem geeigneten Material (13) ganz oder teilweise gefüllt und dann im NVD-Verfahren beschichtet (14).
   b) Die Kühlkanäle werden vor der Beschichtung mit einem anderen Verfahren z.B. Galvanik abgedeckt (15) und dann im NVD-Verfahren beschichtet.
   c) Die Kühlkanäle werden an der zu beschichtenden Oberfläche mechanisch oder chemisch so bearbeitet (16a, 16b, 16c), dass eine konturierte Geometrie oder formschlussartige Mikrostrukturen entstehen, die eine NVD-Hohlraumabscheidung ermöglichen und damit eine formschlüssige Verbindung zwischen Tragstruktur und Grundstruktur gegeben ist. Die Kühlkanalabdeckung vor der Beschichtung erfolgt mit einem geeigneten Füllmaterial (13).
   d) Aufbau mit molekularer Anbindung der NVD-Schicht an die Grundstruktur mittels geeigneter chemischer oder galvanotechnischer Vorbehandlung der zu beschichtenden Oberflächen.

Bei den Beschichtungsarten A)a) und A)b) ist eine molekulare Verbindung mit dem Grundkörper wünschenswert, aber nicht unbedingt erforderlich.
B) Beschichtungsseitig geschlossene Kühlkanäle (15):
   a) Aufbau mit molekularer Anbindung der NVD-Schicht an die Grundstruktur mittels geeigneter chemischer oder galvanotechnischer Vorbehandlung der zu beschichtenden Oberflächen.
   b) Aufbau ohne Anbindung der NVD-Schicht an die Grundstruktur zur Vermeidung thermischer Zwangskräfte bei Einwirkung unterschiedlicher Temperaturen. Werkstoff- oder anwendungsbedingt ist auch eine mehr oder minder dicke Trennschicht mittels geeigneter Vorbehandlung der zu beschichtenden Oberflächen denkbar.
   c) Die zu beschichtenden Oberflächen werden mechanisch oder chemisch so bearbeitet, dass eine Geometrie entsteht, die eine NVD-Hohlraumabscheidung ermöglicht und somit eine formschlüssige Verbindung zwischen Tragstruktur und Grundstruktur erreicht wird.
   d) Die zu beschichtenden Oberflächen sind werkstoff- oder herstellungsbedingt so porös, dass eine NVD-Hohlraumabscheidung möglich wird und somit eine formschlüssige Verbindung zwischen Tragstruktur und Grundstruktur gegeben ist.

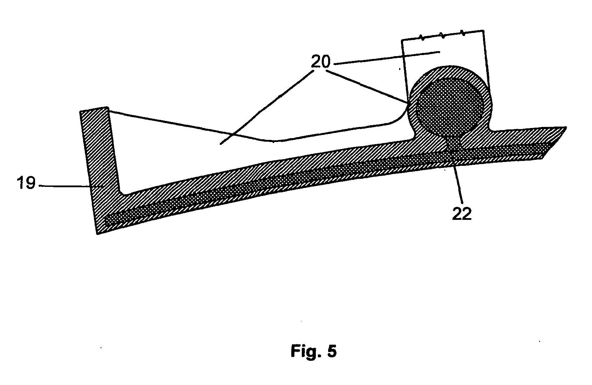

Als nächstes wird die Herstellung von Brennkammer-Grundkörpem aus NVD-Nickel mit integrierten Kühlkanälen beschrieben. (Fig. 5)

Für bestimmte Triebwerkstypen oder bei Verwendung bestimmter Treibstoffe ist ein Brennkammer-Grundkörper aus 100% Nickel von Vorteil. Das NVD-Verfahren eignet sich sowohl für die Herstellung einer mit Rippen versehenen Grundstruktur (Liner) als auch für die Herstellung eines mit Kühlkanälen versehenen integralen Gesamtkörpers.
a) Grundstruktur (Liner)
   Herstellung der berippten Grundstruktur durch Abscheidung des NVD-Nickels auf einer entsprechend gestalteten Negativform. Wandstärken und Fertigkontur der berippten Grundstruktur können anschließend durch Bearbeitung angepasst und optimiert werden.
b) Integraler Grundkörper mit Tragstruktur
   Die kühlmittelführenden Hohlräume (22) werden aus geeigneten Werkstoffen als verlorene Kerne nachgebildet und anschließend mit NVD-Nickel (19) beschichtet. Wandstärken und Fertigkontur (20) des Grundkörpers können anschließend durch Bearbeitung angepasst und optimiert werden. Die Hohlräume entstehen dadurch, dass das Kemmaterial nach dem Beschichtungsvorgang mit geeigneten Hilfsmitteln herausgelöst wird.

Als nächstes wird die Herstellung von Tragstrukturen auf keramischen Bauteilen gemäß dem erfinderischen Verfahren beschrieben. (Fig.4)

Das abgeschiedene Nickel dringt dabei in die poröse Oberfläche (18) ein, verankert sich und bildet bei fortgesetzter Beschichtung die Basis für den strukturellen Aufbau (17).

Als nächstes wird die Beschichtung keramischer Bauteile zur Oberflächenabdichtung gemäß dem erfinderischen Verfahren beschrieben. (Fig. 4)

Das im NVD-Verfahren abgeschiedene Nickel füllt die bei keramischen Bauteilen aus dem Prozess gegebenen Poren aus. Dadurch erfolgt auf der Oberfläche (18) eine Abdichtung gegenüber Gasen oder Flüssigkeiten. Bei thermisch hoch belasteten Bauteilen ist dabei die hohe Duktilität des NVD-Nickels von Vorteil.

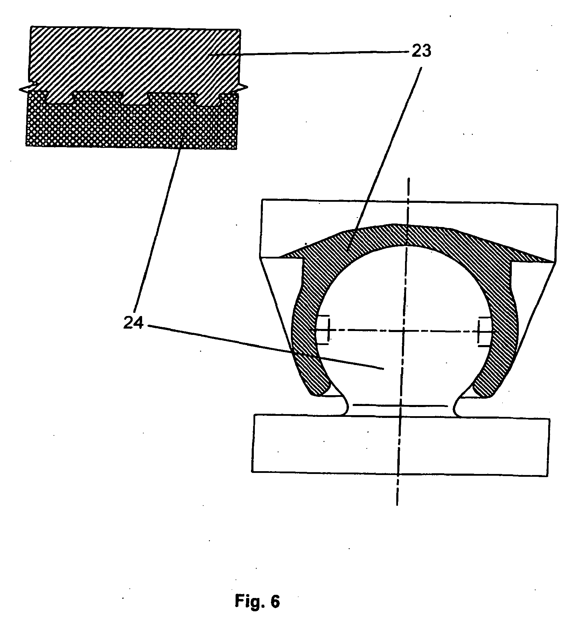

Als nächstes wird die Herstellung von Verbindungselementen auf keramischen Grundstrukturen beschrieben. (Fig. 5 und 6)

Im NVD-Verfahren können derzeit Nickel-Schichtdicken von über 35mm aufgebracht werden. Die hohen Schichtdicken bieten die Möglichkeit an den beschichteten Bauteilen direkt Verbindungselemente wie Flansche (19), Zu- und Abströmverteiler (20) und Verstärkungsringe (21) mit aufzubauen oder durch nachträgliche mechanische Bearbeitung der NVD-Schicht zu erzeugen.

Als nächstes wird die mechanische Verbindung von Grundkörpern mit einem Nickelmantel beschrieben. (Fig. 6)

Das oben beschriebene Verfahren zur Verbindung von Kühlkanalsegmenten mit einem Nickelmantel kann generell genutzt werden. Dies ist von besonderem Interesse, wenn Nickelbeschläge (23) mit Materialien unterechiedlicher Eigenschaften (24) und komplexer Geometrie spaltfrei verbunden werden sollen. Beispiele wären Nickel-Verbundbauweisen mit folgenden Materialien: Keramik, Faserverbund-Werkstoffe, Metalle.

Als nächstes wird die NVD-Abscheidung in Kombination mit einer Lötverbindung beschrieben. (Fig. 1 und 2)

Der Grundkörper wird im Bereich der Bindezone zum NVD-Nickel oder einem Teilbereich davon galvanisch mit einem geeigneten Lot beschichtet. Alternativ kann das Lotmaterial auch in Folienform auf den Grundkörper aufgebracht werden. Danach erfolgt die NVD-Beschichtung. Anschließend wird der Lötprozess in einem Lötofen durchgeführt. Das beschriebene Verfahren hat den Vorteil, dass speziell bei großen zu verbindenden Bauteilen ein genauer Formschluss gegeben ist. Auch bei komplexer und hinterschnittene Formgebung der Bindezone sowie bei Toleranzschwankungen aus dem Fertigungsprozess der Einzelteile gewährleistet dieses Verfahren einen gleichförmigen Lötspalt.

Bei Brennkammern könnte auf diese Weise der Grundkörper (10) an der Bindefläche (25) zum Nickelmantel mit Lot überzogen werden. Anschließend werden die Kühlkanäle gefräst und mit geeignetem Material gefüllt (13), bevor die spaltfreie Auftragung des Nickelmantels (14) mittels NVD-Beschichtung erfolgt. Nach dem Beschichtungsvorgang wird der Lötprozess zwischen Grundkörper und NVD-Schicht durchgeführt.

## Patentansprüche

1. Verfahren zur Herstellung von Bauteilen für den Raketenbau, umfassend die Schritte:
- Bereitstellen eines Grundkörpers (10);
- Abscheidung von Nickel im NVD-Verfahren auf den Grundkörper (10); und
- Weiterbearbeitung der Verbindung des Grundkörpers (10) mit der Nickelschicht (14) als Bauteil;
**gekennzeichnet durch** die Schritte:
- Verwendung eines Bauteils einer Rakete als Grundkörper (10), wobei das Bauteil eine poröse keramische und/oder eine nichtkeramische Faserverbundstruktur umfasst, wobei **durch** die Abscheidung von Nickel eine Oberflächenabdichtung gegen Gase und Flüssigkeiten bewirkt wird.

2. Verfahren nach Anspruch 1, bei dem das Bauteil einer Rakete gekühlt oder nicht gekühlt ist.

3. Verfahren nach einem der vorherigen Ansprüche, bei dem als zusätzlicher Schritt vor dem Schritt des Abscheidens von Nickel auf das Bauteil einer Rakete im Bereich der Bindezone zum NVD-Nickel oder einem anderen Teilbereich davon der Grundkörper galvanisch mit einem Lot beschichtet wird.

4. Verwendung eines NVD-Verfahrens zur Abscheidung von Nickel auf einem Grundkörper (10), der ein Bauteil einer Rakete ausbildet und der eine poröse keramische und/oder nichtkeramische Faserverbundstruktur umfasst, zur Ausbildung einer Beschichtung zur Oberflächenabdichtung gegen Gase und Flüssigkeiten.

## Claims

1. Method for manufacturing components for rocket construction, comprising the steps:
- providing a main body (10);
- depositing nickel on the main body (10) in an NVD process; and
- further processing the connection of the main body (10) to the nickel layer (14) as a component;
**characterized by** the steps:
- using a component of a rocket as a main body (10), wherein the component comprises a porous ceramic and/or a non-ceramic fibre composite structure, wherein sealing of the surface with respect to gases and liquids is realized by means of the deposition of nickel.

2. Method according to Claim 1, in which the component of a rocket is cooled or non-cooled.

3. Method according to one of the preceding claims, in which, as an additional step before the step of the deposition of nickel on the component of a rocket, the main body is galvanically coated with a solder in the region of the fusion zone to the NVD nickel or in another sub-region thereof.

4. Use of an NVD process for the deposition of nickel on a main body (10), which forms a component of a rocket and which has a porous ceramic and/or non-ceramic fibre composite structure, for forming a coating for sealing the surface with respect to gases and liquids.

## Revendications

1. Procédé de fabrication de composants pour la construction de raquettes, comprenant les étapes de :
- fourniture d'un corps de base (10) ;
- dépôt de nickel dans un procédé NVD sur le corps de base (10) ; et
- traitement ultérieur du composé constitué par le corps de base (10) et la couche de nickel (14) en tant que composant ;
**caractérisé par** les étapes :
- d'utilisation d'un composant d'une raquette en tant que corps de base (10), le composant comprenant une structure composite renforcée par des fibres poreuse, céramique et/ou non céramique, une étanchéité aux gaz et aux liquides étant réalisée par le dépôt de nickel.

2. Procédé selon la revendication 1, dans lequel le composant d'une raquette est refroidi ou non refroidi.

3. Procédé selon l'une quelconque des revendications précédentes, dans lequel, en tant qu'étape supplémentaire avant l'étape de dépôt de nickel sur le composant d'une raquette, dans la région de la zone de liaison au nickel NVD ou une autre région partielle de celui-ci, le corps de base est revêtu galvaniquement d'une brasure.

4. Utilisation d'un procédé NVD pour le dépôt de nickel sur un corps de base (10), qui constitue un composant d'une raquette et qui comprend une structure composite renforcée par des fibres poreuse, céramique et/ou non céramique, pour la réalisation d'un revêtement pour l'étanchéité de la surface aux gaz et aux liquides.
